# EUROPEAN PATENT APPLICATION

(11) **EP 4 814 511 A1**
(43) Date of publication of application: **30.09.2026**
(21) Application number: 25166112.0
(22) Date of filing: 25.03.2025
(51) Int. Cl.: G01R 31/392

(54) **METHOD FOR DETERMINING BATTERY HEALTH AND SYSTEM THEREFOR**

(71) Applicant: Nederlandse Organisatie voor toegepast- natuurwetenschappelijk onderzoek TNO, 2595 DA 's-Gravenhage (NL)
(72) Inventor: Meulenbroeks, Tim Antoni Jozef, 2595 DA 's-Gravenhage (NL); Dadikozyan, Avedis Agop, 2595 DA 's-Gravenhage (NL)
(74) Representative: V.O.

(57) **Abstract**

A method and system for determining battery health (C,R) of a battery (11) powering an electric system (10). A controller (30) controls a charging system (20) to execute a diagnostic protocol (P) comprising charging and/or discharging the battery (11). A monitoring device (12), integrated as part of the electric system (10), monitors one or more characteristics (V,I,T) of the battery (11) while the diagnostic protocol (P) is executed. A processor (40) determines the battery health (C,R) based on a combination of the executed diagnostic protocol (P) and the received one or more characteristics (V,I,T). The method of determining battery health (C,R) is used in a method of charging the battery (11). The diagnostic protocol (P) is executed and the battery is charged up to a predefined state of charge that is based on the battery health (C,R) determined by using the diagnostic protocol (P).

## Description

### TECHNICAL FIELD AND BACKGROUND

The present disclosure relates to a method and system for determining battery health, in particular during a regular charging cycle of the battery.

Battery health may refer to the condition of a battery, e.g., in absolute terms or relative to its original state. It may encompass various parameters such as the amount of charge the battery can (safely) store and deliver, its internal resistance. Also other or further parameters may be used, such as the battery's ability to maintain performance over multiple charge-discharge cycles, the rate of self-discharge, the battery's thermal stability, voltage retention under load, and efficiency in energy conversion, uniformity of charge distribution among individual cells in a battery pack, the extent of capacity fade over time, and the response of the battery to varying operating conditions such as temperature and load fluctuations.

Over time, chemical and mechanical processes may lead to changes in these properties, affecting energy storage capacity, power delivery, efficiency, and overall lifespan. In applications such as electric vehicles (EVs), portable electronics, and energy storage systems, assessing battery health may be relevant for ensuring reliable operation, optimizing charging strategies, and preventing unexpected failures.

In general, battery health may be assessed using parameters such as State of Charge (SOC), Depth of Discharge (DOD), and State of Health (SOH). SOC may represent the available energy relative to the battery's total capacity, while DOD may indicate the percentage of discharged capacity in a given cycle. SOH may quantify degradation by comparing the current battery condition to an earlier or initial state. Additionally, internal resistance measurements may provide insight into power delivery losses. Conventional methods for determining these parameters may involve laboratory testing, impedance meters, or model-based estimations, which may be subject to accuracy limitations, repeatability concerns, or constraints in practical applications.

During regular use, such as charging or discharging, battery management systems (BMS) may monitor voltage, current, and temperature. However, BMS implementations may rely on manufacturer-specific algorithms that do not necessarily provide accurate or transparent battery health estimations. Furthermore, conventional methods for measuring internal resistance and capacity may require specialized equipment or controlled conditions that may not always be feasible in practical applications.

There remains a need for methods and systems that may allow battery health to be determined accurately and reproducibly during regular operation, without requiring specialized equipment and/or full charge-discharge cycles.

### SUMMARY

Aspects of the present disclosure relate to a method of determining battery health of a battery powering an electric system. The method comprises controlling, via a controller, a charging system to execute a diagnostic protocol comprising charging and/or discharging the battery; receiving, from a monitoring device integrated as part of the electric system, one or more characteristics of the battery while executing the diagnostic protocol; and determining, by a processor, the battery health based on a combination of the executed diagnostic protocol and the received one or more characteristics.

By determining the battery health at a controllable charging system, the battery health can be estimated more accurately and reproducibly as compared to estimating the battery health during its usage, e.g. based on on-board/usage diagnostics. By monitoring one or more characteristics of the battery, during charging and/or discharging at the controllable charging system, accuracy, reproducibility and time needed to estimate the battery health is improved.

By measuring voltage of the individual battery cells and keeping the maximum and minimum of the cell voltages within a predefined range damage to the battery can be prevented during determining the battery health. Advantegously, by monitoring the actual battery cell voltages a more reliable battery health estimation can be obtained than using a reported SOC, e.g. SOC displayed on a dashboard. By integrating current over time while charging and/or discharging the battery between predetermined set points based on the measured battery cell voltages, robust, reproducible, and fast measurement of the battery health can be obtained. By identifying the battery and/or the electric system, different predetermined set points can be obtained for different batteries and/or electric systems.

By determining the battery health based on both charging and discharging of the battery, e.g. at a bi-directional charger, the battery health can be estimated more accurately and reproducibly as compared to estimating the battery health based on on-board/usage diagnostics only. Advantegously, the battery remains charged when the diagnostic protocol comprises executing a sequential discharge phase followed by a subsequent charge phase of the battery.

By providing a rest period before and/or after a discharge phase or a charge phase, the battery, e.g. electrochemical interactions inside the battery cells, can settle down before and/or after the respective phase, thereby improving the accuracy of determining the battery health. By bringing the battery in a predefined state, e.g. by sequentially charging and discharging the battery, effect of hysteresis and/or current state of charge on determining the battery health can be minimized.

Advantageously, by drawing constant current from the battery followed by maintaining constant voltage over the battery, under- or overshooting of the destination voltage can be minimized thereby establishing a robust voltage set point for measuring battery health, e.g. by integrating current over time between two predetermined (voltage) set points. Alternatively, or in addition, the battery health can be adjusted for an under- or overshoot of a desired destination voltage.

By providing predetermined different amounts of current to the battery, e.g. related to a maximum current needed to fully charge the battery, the non-linear relationship between internal resistance and voltage of the battery can be determined. Advantageously, the internal resistance can be accurately determined based on drawing/injecting current from/to the battery at a constant rate that is predetermined based on a measured charging capacity of the battery.

Other aspects of the present invention relate to a method of charging a battery powering an electric system. The method comprises executing a diagnostic protocol and charging the battery up to a predefined state of charge, wherein the predefined state of charge is based on the battery health determined by using the diagnostic protocol.

Yet other aspects of the present invention relate to a system for determining battery health of a battery powering an electric system. The electric system comprises a controller for controlling a charging system to execute a charging protocol for charging and/or discharging the battery; a receiver for receiving, from a monitoring device integrated as part of the electric system, one or more characteristics of the battery while executing the charging protocol; and a processor for determining the battery health based on a combination of the executed charging protocol and received one or more characteristics.

### BRIEF DESCRIPTION OF DRAWINGS

These and other features, aspects, and advantages of the apparatus, systems and methods of the present disclosure will become better understood from the following description, appended claims, and accompanying drawing wherein:
FIGs 1A - 1B illustrate a method of determining battery health of an electric system;
FIGs 2A - 2D illustrate a diagnostic protocol comprising measuring a charging capacity;
FIGs 3A - 3B illustrate a diagnostic protocol comprising measuring internal resistance and a system for determining battery health.

### DESCRIPTION OF EMBODIMENTS

Terminology used for describing particular embodiments is not intended to be limiting of the invention. As used herein, the singular forms "a", "an" and "the" are intended to include the plural forms as well, unless the context clearly indicates otherwise. The term "and/or" includes any and all combinations of one or more of the associated listed items. It will be understood that the terms "comprises" and/or "comprising" specify the presence of stated features but do not preclude the presence or addition of one or more other features. It will be further understood that when a particular step of a method is referred to as subsequent to another step, it can directly follow said other step or one or more intermediate steps may be carried out before carrying out the particular step, unless specified otherwise. Likewise it will be understood that when a connection between structures or components is described, this connection may be established directly or through intermediate structures or components unless specified otherwise.

The invention is described more fully hereinafter with reference to the accompanying drawings, in which embodiments of the invention are shown. In the drawings, the absolute and relative sizes of systems, components, layers, and regions may be exaggerated for clarity. Embodiments may be described with reference to schematic and/or cross-section illustrations of possibly idealized embodiments and intermediate structures of the invention. In the description and drawings, like numbers refer to like elements throughout. Relative terms as well as derivatives thereof should be construed to refer to the orientation as then described or as shown in the drawing under discussion. These relative terms are for convenience of description and do not require that the system be constructed or operated in a particular orientation unless stated otherwise.

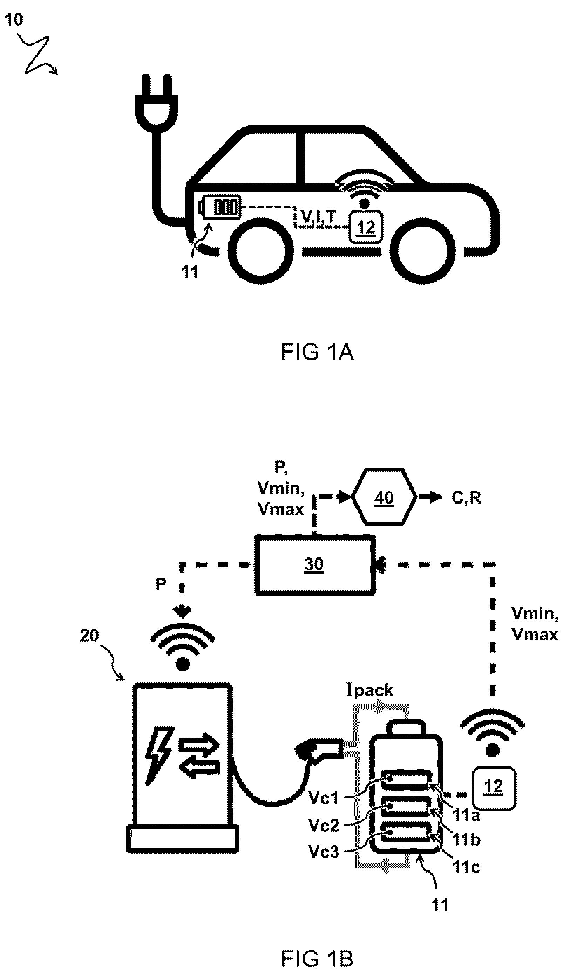

FIGs 1A - 1B illustrate a method of determining battery health of a battery 11 powering an electric system 10. The method comprises controlling, via a controller 30, a charging system 20 to execute a diagnostic protocol "P" comprising charging and/or discharging the battery 11. The method further comprises receiving, from a monitoring device 12 integrated as part of the electric system 10, one or more characteristics of the battery 11 while executing the diagnostic protocol "P". The method further comprises determining, by a processor 40, the battery health based on a combination of the executed diagnostic protocol "P" and the received one or more characteristics. For example, the one or more characteristics may include one or more voltages "V" of the battery 11. Alternatively, or in addition, also a current "I" passing through the battery may be included as one of the characteristics. The current "I" may also be derived from and/or set by the charging system 20. Also other or further characteristics of the battery 11 and/or electric system 10 may be received from the monitoring device 12, such as the temperature "T".

In some embodiments, determining the battery health comprises determining a charging and/or discharging capacity "C" of the battery 11. In other or further embodiments, determining the battery health comprises determining an internal resistance "R" of the battery 11. For example, the charging capacity "C" and/or resistance "R" may be determined based on measuring voltage and/or current.

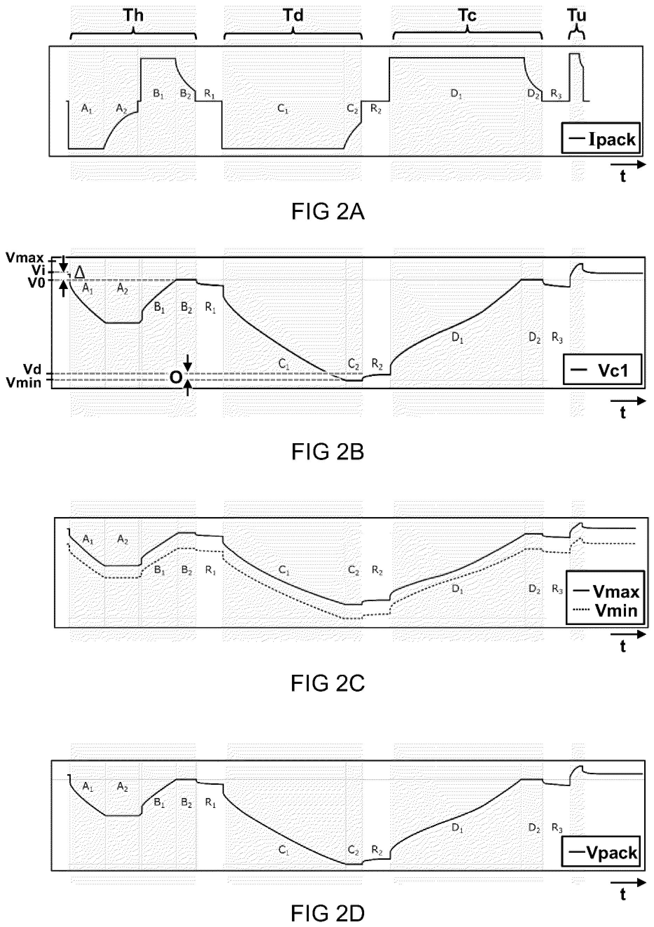

Also other or further parameters may be determined for characterizing battery health. In one embodiment, determining the battery health may include determining an energy round trip efficiency, e.g. based on integrating a product of voltage and current over time. For example, a first product of voltage and current can be integrated over time during charging and a second product of voltage and current can be integrated over time during discharging. The first product can be divided by the second product to obtain the energy round trip efficiency. In another or further embodiment, determining the battery health may include determining a voltage imbalance ratio. For example, a first difference between a minimum and maximum cell voltage of the battery 11 can be calculated at the end of a first rest period R1, e.g. as illustrated in FIG 2B, and a second difference between a minimum and maximum cell voltage of the battery 11 can be calculated at the end of a second rest period R2, e.g. as illustrated in FIG 2B. The first difference can be divided by the second difference to obtain the voltage imbalance ratio.

In some embodiments, the determination of the battery health may include measurement of one or more temperatures associated with the battery. In one embodiment, the determined battery health is calibrated and/or compensated based on measuring a temperature of the battery 11. For example, a charging capacity "C" and/or internal resistance "R" measured at a specific temperature may be adjusted based on a reference temperature and/or reference model. This may allow alleviate temperature dependence when comparing the battery health between different measurements and/or circumstances. The battery may comprise a lithium-ion battery or other sort of battery suitable for electronic systems. The electric system may comprise an electric vehicle, e.g. car (as illustrated in FIG 1A), ship, drone, airplane, bike, motorbike; a stationary energy storage system, e.g. back-up unit, a portable electronic device, e.g. mobile phone, laptop, watches, camera; a smart home appliance, e.g. speakers, doorbell, security camera's; or other sort of a portable or wireless electronic devices.

In some embodiments, controlling of the charging system 20 may comprise instructing the charging system 20 to provide/draw a predetermined amount of current and/or charge over time to/from the electric system 10 and/or to maintain a specific voltage over the battery 11 of the electric system 10. In other or further embodiments, the diagnostic protocol "P" comprises measuring of at least one of voltage, current, or temperature of the battery 11. Preferably, the controller 30 and the processor 40 are at a remote location, e.g. integrated in a remote cloud platform "N". Alternatively, the controller 30 and/or the processor 40 can be integrated in the charging system 20 and/or the electric system 10. Preferably, e.g. as illustrated in FIG 1B, the controller 30 is receiving, from the monitoring device 12, the one or more characteristics "V", "I" , and/or "T" via a wireless signal transmission. Alternatively, or in addition, the one or more characteristics can be received via a charging charge cable 20c connecting the electric system 10 to the charging system 20. Preferably, e.g. as also illustrated in FIG 1B, the controller 30 is controlling the charging system 20 via a wireless signal transmission. Alternatively, or in addition, the controller 30 is integrated in the charging system 20.

FIGs 2A - 2D illustrate an example of a diagnostic protocol "P" for measuring a charging capacity of a battery 11, e.g. as was illustrated in FIGs 1A and 1B. In some embodiments, e.g. as shown in FIG 1B, the battery 11 comprises a plurality of individual battery cells 11a,11b,11c having a plurality of individual cell voltages Vc1,Vc2,Vc3, forming a battery pack. While FIG 1B illustrates only three cells, it will be understood that in general the battery pack may comprise any number of cells.

In some embodiments, the one or more characteristics "V", "I", and/or "T" received from the monitoring device 12, e.g. as illustrated in FIG 1A, comprises at least one individual cell voltage Vmin and/or Vmax of the plurality of individual cell voltages Vc1,Vc2,Vc3, e.g. as illustrated in FIG 1B. In one embodiment, the plurality of individual cell voltages Vc1,Vc2,Vc3 of the plurality of individual battery cells 11a,11b,11c and/or the at least one individual cell voltage Vmin and/or Vmax of the plurality of individual cell voltages Vc1,Vc2,Vc3 may be measured by a battery management system (BMS) of the electric system 10. One or more of said measured voltages may be read out by the monitoring device 12 and transmitted to the controller 30. For example, the measured voltages and/or other data, such as temperature, measured by the BMS may be put on a Controller Area Network (CAN) bus of the electric system 10, e.g. vehicle, and/or the measured voltages may be read out from the CAN bus by the monitoring device 12. Also other ways of transmitting data between the BMS and monitoring device 12 may be envisaged and/or the monitoring device 12 may be integrated as part of the BMS.

In other or further embodiments, based on the at least one individual cell voltage Vmin and/or Vmax, the controller 30 is configured to control the charging and/or discharging of the battery 11 by controlling a battery pack current Ipack and/or battery pack voltage "Vpack" to and/or from the battery pack. The processor 40 is configured to determine a charging capacity "C" of the battery 11 by integrating the battery pack current Ipack over time between a predetermined first set point, based on the at least one individual cell voltage Vmin and/or Vmax, and a predetermined second set point, based on the same or another at least one individual cell voltage Vmin and/or Vmax.

In some embodiments, the at least one individual cell voltage Vmin and/or Vmax is at least one of a minimum cell voltage Vmin measured among the cell voltages Vc1,Vc2,Vc3 of the plurality of individual battery cells 11a,11b,11c, and a maximum cell voltage Vmax measured among the cell voltages Vc1,Vc2,Vc3 of the plurality of individual battery cells. For example, the battery 11 may comprise NiMnC-based cells having a typical minimum cell voltage Vmin of 2,5 V and a typical maximum cell voltage Vmax of 4,2 V. In yet another or further embodiment, the at least one individual cell voltage Vmin and/or Vmax is a target cell voltage. For example, in the case of NiMnC-based cells, is the minimum target cell voltage 3,4 V and the maximum target cell voltage is 3,9 V.

In some embodiments, the processor 40 is configured to determine a charging capacity "C" of the battery 11 by integrating the battery pack current Ipack over time between a predetermined first set point, based on the minimum cell voltage Vmin, and a predetermined second set point, based on the maximum cell voltage Vmax. In one embodiment, the battery pack current Ipack is integrated over time by a battery management system of the electric system 10, monitored by the monitoring device 12 and transmitted to the controller 30. In another or further embodiment, the battery pack current Ipack provided to the electric system 10 is integrated over time by the charging system 20 and transmitted to the controller 30. Alternatively, or in addition, the amount of current that has been instructed by the controller 30 to be provided, by the charging system 20, to the electric system 10 can be used as an estimation of integrating the battery pack current Ipack over time.

In some embodiments, the charging capacity "C" of the battery 11 determined between the first and second set points is converted to a state of charge of the battery 11. For example, a look-up table can be used to convert the charging capacity "C" of the battery 11 determined at a given temperature to the state of charge of the battery 11 at the same or another, e.g. reference, temperature. Different look-up tables can be used to relate the charging capacity "C" to the state of the charge at different temperatures. Alternatively, or in addition, the respective set points are converted to the respective state of charges and the charging capacity "C" is determined between a first and a second state of charge of the battery 11. Different look-up tables can be used to relate the respective set point to the respective state of charge at different temperatures. This embodiment is preferred when the temperature of the battery 11 changes during executing the diagnostic protocol "P".

In other or further embodiments, the first and/or second predetermined set point is based on identification of the battery 11 and/or the electric system 10 comprising the battery 11, e.g. MAC address and/or serial number of the electric system 10 and/or the battery 11, vehicle identification number of an electric vehicle comprising the battery 11, etc.

In some embodiments, the diagnostic protocol "P" comprises executing a discharge phase "Td" followed by a charge phase "Tc" of the battery 11. For example, as illustrated in FIGs 2A and 2D, the discharge phase "Td" comprises a first period of discharging the battery at a constant current "C1" (FIG 2A), a second period of maintaining a constant voltage over the battery after the discharging "C2" (FIG 2D), a first period of charging the battery at a constant current "D1" (FIG 2A), and a second period of maintaining a constant voltage over the battery after the charging "D2" (FIG 2D). Optionally, the charge phase "Tc" may be followed by a rest time "R3" and a top-up phase "Tu" to end up with a battery charged at a full voltage "Vf", e.g. as illustrated in FIG 2A.

In other or further embodiments, the diagnostic protocol "P" comprises at least one rest period "R1,R2,R3" before and/or after the discharge phase "Td" or the charge phase "Tc". In one embodiment, e.g. as illustrated in FIG 2A, the diagnostic protocol "P" comprises a first rest period "R1" before the discharge phase "Td", a second rest period "R2" after the discharge phase "Td", and/or before the charge phase "Tc", and/or a third rest period "R3" before another charge phase, e.g. a top-up phase "Tu". in some embodiments, the charging system 20 is maintained in an idle state during the at least one rest period, e.g. no current is provided/drawn by the charging system 20 to/from the battery 11. In one embodiment, the at least one rest period "R1","R2","R3" is longer than a respective preceding period of maintaining a constant voltage over the battery pack, e.g. "B2","C2", and/or "D2" period', by at least ten, preferably fifty, even more preferably one hundred or more percent.

In some embodiments, the diagnostic protocol "P" further comprises a calibration phase "Th" configured to bring the battery 11 in a predefined state by at least one of charging the battery 11 from an initial cell voltage "Vi", that is above a predetermined baseline cell voltage "V0", and subsequently discharging the battery 11 to the predetermined baseline cell voltage "V0"; or discharging the battery 11 from an initial cell voltage "Vi", that is below a predetermined baseline cell voltage "V0", and subsequently charging the battery 11 to the predetermined baseline cell voltage "V0". In one embodiment, e.g. as illustrated in FIGs 2A and 2D, the calibration phase "Th" comprises a first period of discharging the battery pack at a constant current "A1" (FIG 2A), a second period of maintaining a constant voltage over the battery pack after the discharging "A2" (FIG 2D), a first period of charging the battery pack at a constant current "B1" (FIG 2A), and a second period of maintaining a constant voltage over the battery pack after the charging "B2" (FIG 2D).

In other or further embodiments, e.g. as illustrated in FIG 2B, the charging and/or discharging the battery 11 from the initial cell voltage "Vi" is based on a difference "Δ" between the initial cell voltage "Vi" and the predetermined baseline voltage "V0" of the battery cells. For example, if the difference "Δ" between the initial voltage of the battery "Vi" and the baseline voltage "V0" is smaller than a predefined value then the battery 11 is first discharged, and subsequently charged to arrive at the predetermined baseline voltage "V0" from below. Alternatively, or in addition, the battery 11 is first charged, and subsequently discharged to arrive at the predetermined baseline voltage "V0" from above.

In some embodiments, e.g. as illustrated in FIGs 2B and 2D, charging and/or discharging of the battery 11 comprises providing a constant battery pack current Ipack to the battery 11 until reaching a predetermined offset "O" from a destination cell voltage "Vd" (FIG 2B); and keeping a battery pack voltage "Vpack" constant to reach the destination cell voltage "Vd" (FIGs 2B and 2D). In some embodiments, providing the constant current to the battery 11 comprises drawing constant current or injecting constant current to the battery 11. In other or further embodiments, e.g. as can be seen in FIGs 2A and 2D, after drawing constant battery pack current Ipack from the battery ("C1" period in FIG. 2A) and subsequently keeping the battery pack voltage "Vpack" constant ("C2" period in FIG 2D), the battery pack current Ipack asymptotically increases as the cells of the battery 11 equilibrate ("C2" period in FIG 2A). Similarly, as also illustrated in FIGs 2A and 2D, after injecting battery pack current Ipack to the battery 11 ("D1" period in FIG 2A) and subsequently keeping the battery pack voltage "Vpack" constant ("D2" period in FIG 2D), the battery pack current Ipack asymptotically decreases as the cells of the battery 11 equilibrate ("D2" period in FIG 2A).

In some embodiments, e.g. when a desired destination voltage "Vd" cannot be accurately reached, the battery health can be adjusted for an under- or overshoot of the desired destination voltage "Vd". For example, current drawn by the battery 11 after reaching the destination voltage "Vd" is integrated over time and subtracted from a total amount of current provided to the battery 11 to reach the destination voltage "Vd". In another example, amount of current required to bridge an undershoot of the destination voltage "Vd" is estimated based on an amount of current provided to the battery 11 to reach the undershoot, integrated over time and added to the total amount of current provided.

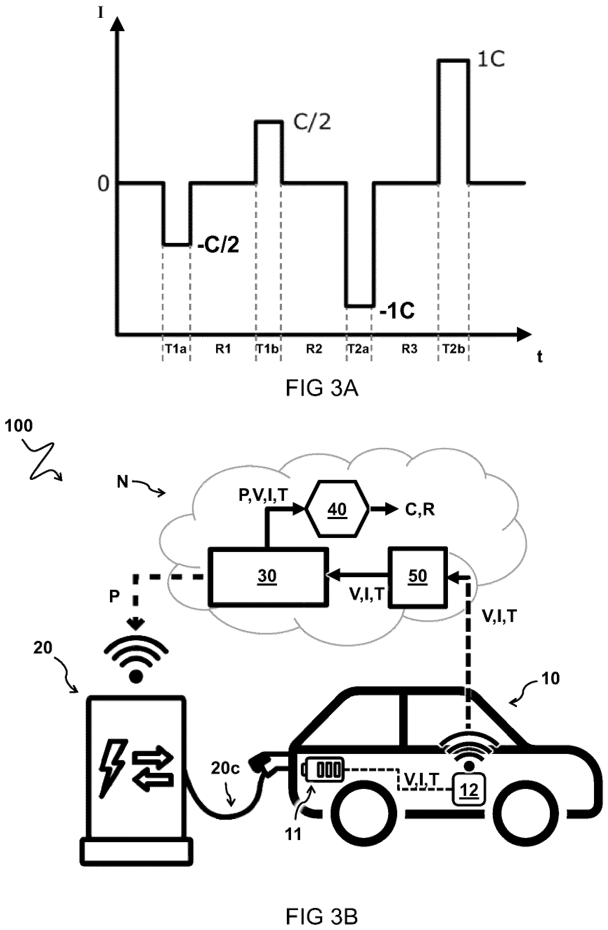

FIG 3A illustrates a diagnostic protocol "P" comprising measuring internal resistance of a battery 11. In some embodiments, determining the battery health comprises measuring internal resistance "R" of the battery 11 by drawing/injecting different amounts of current from/to the battery 11 at a constant rate while measuring current and voltage of the battery 11 and determining the internal resistance of the battery 11 based on the measuring current and voltage to the battery 11. In one embodiment, the respective different amounts of current are a fraction of the amount of current needed to fully charge the battery 11 in a predetermined period of time. In other or further embodiments, e.g. as illustrated in FIG 3A, drawing/injecting different amounts of current from/to the battery 11 at a constant rate comprises a first period of drawing current "T1a" at a first rate "-C/2"; a first period of injecting current "T1b" at the first rate "C/2"; a second period of drawing current "T2a" at a second rate "-C/2"; and a second period of injecting current "T2b" at the second rate "-1C". In one embodiment, the first periods of drawing/injecting current at the first rate "T1a","T1b" and the second periods of drawing/injecting at the second rate "T1a","T1b" are equally long, e.g. one second, preferably ten seconds, the most preferably one hundred seconds or more. In some embodiments, the periods of drawing and injecting current at the respective rates are separated by a rest period "R1", "R2", "R3". In one embodiment, the rest period "R1", "R2", "R3" is longer than the period of drawing/injecting the current "T1a","T1b", "T2a","T2b" by at a factor of ten, preferably sixty, the most preferably hundred or more. In other or further embodiments, the first and second rates are determined as a fraction of the amount of current needed to fully charge the battery 11 in a predetermined period of time. For example, if a battery has a capacity of 100 Ah, a 1C discharge rate means the battery is discharged at 100 A, and it would be fully depleted in 1 hour. Similarly, a 1C charge rate means the battery is charged at 100 A, and it would be fully charged in 1 hour. In one embodiment, the absolute value of the first rate is equal to C/2 and the absolute value of the second rate is equal to 1C. In another or further embodiment, the second rate is different from the first rate by a factor of two, preferably five, the most preferably ten.

In some embodiments, the determined internal resistance "R" of the battery 11 is compensated for a state of charge of the battery 11. For example, a look-up table can be used to convert the determined internal resistance "R" of the battery 11 to a reference internal resistance "R" independent of the state of charge of the battery 11. Different look-up tables can be used to compensate the internal resistance "R" for the state of charge at different temperatures.

Advantageously, the battery health determined by the diagnostic protocol "P" is used in a method of charging a battery 11 powering an electric system 10, e.g. as illustrated in FIG 2B. The method comprises executing the diagnostic protocol "P" according to one of the preceding claims; and charging the battery 11 up to a predefined state of charge, e.g. percentage or fraction of a charging capacity "C" of the battery 11 determined by using the diagnostic protocol "P". In one embodiment, a non-transitory computer-readable medium stores instructions that, when executed by one or more processors, cause a device to perform the method of charging and/or determining the battery health. In another or further embodiment, the method of determining the battery health is executed automatically, e.g. when a charging cable is connected and/or charging session is initiated and/or without requiring user initiation of the protocol.

FIG 3B illustrates a system for determining battery health of a battery 11 powering an electric system 10. The electric system 10 comprises a controller 30 for controlling a charging system 20 to execute a charging protocol for charging and/or discharging the battery 11; a receiver 50 for receiving, from a monitoring device 12 integrated as part of the electric system 10, one or more characteristics "V", "I", and/or "T" of the battery 11 while executing the charging protocol; and a processor 40 for determining the battery health based on a combination of the executed charging protocol and received one or more characteristics. In one embodiment, the charging system 20 is a bi-directional charger configured to reproducibly charge, discharge, or rest when connected to a battery 11 of an electric system 10. In another or further embodiment, the monitoring device 12 comprises a transmitter configured to transmit data to the receiver 50 using a wireless signal transmission, e.g. 4/5g, Bluetooth, WiFi. Preferably, the receiver 50 is coupled to the controller 30 in a remote cloud platform "N". Alternatively, or in addition, the controller 30 and/or the processor 40 are integrated in the charging system 20 and/or the electric system 10. In other or further embodiments, the monitoring device 12 is configured to relay battery management system data from an electric vehicle over a network to the controller 30 and/or the processor 40 at a remote location. In one embodiment, the electric vehicle comprises an identifier, e.g. a MAC address and/or vehicle identification number. In some embodiments, the monitoring device 12 is configured to rely, e.g. via a wireless transmission, the identifier of the electric vehicle and/or battery to the charging system 20 for initiating the diagnostic protocol "P". Alternatively, or in addition, the MAC address is communicated via a charge cable 20c connecting the charging system 20 with the electric vehicle. In some embodiments, the monitoring device 12 is a battery management system of the electric system 10. In one embodiment, the battery management system is configured to communicate with the charging system 20, e.g. via a wireless signal transmission or charge cable 20c. In yet other or further embodiments, the system 100 for determining battery health is integrated in an electronic device, e.g. a charger and/or power adapter.

In interpreting the appended claims, it should be understood that the word "a" or "an" preceding an element does not exclude the presence of a plurality of such elements; any reference signs in the claims do not limit their scope; several "means" may be represented by the same or different item(s) or implemented structure or function; any of the disclosed devices or portions thereof may be combined together or separated into further portions unless specifically stated otherwise.

## Claims

1. A method of determining battery health (C,R) of a battery (11) powering an electric system (10), the method comprising:
controlling, via a controller (30), a charging system (20) to execute a diagnostic protocol (P) comprising charging and/or discharging the battery (11);
receiving, from a monitoring device (12) integrated as part of the electric system (10), one or more characteristics (V,I,T) of the battery (11) while executing the diagnostic protocol (P); and
determining, by a processor (40), the battery health (C,R) based on a combination of the executed diagnostic protocol (P) and the received one or more characteristics (V,I,T).

2. The method according to the preceding claim, wherein the battery (11) comprises a plurality of individual battery cells (11a,11b,11c), having a plurality of individual cell voltages (Vc1,Vc2,Vc3), forming a battery pack;
wherein the one or more characteristics (V,I,T), received from the monitoring device (12), comprises at least one individual cell voltage (Vmin,Vmax) of the plurality of individual cell voltages (Vc1,Vc2,Vc3);
wherein, based on the at least one individual cell voltage (Vmin,Vmax), the controller (30) is configured to control the charging and/or discharging of the battery (11) by controlling a battery pack current (Ipack) and/or battery pack voltage (Vpack) to and/or from the battery pack; and
wherein the processor (40) is configured to determine a charging capacity (C) of the battery (11) by integrating the battery pack current (Ipack) over time between a predetermined first set point, based on the at least one individual cell voltage (Vmin,Vmax), and a predetermined second set point, based on the same or another of the at least one individual cell voltage (Vmin,Vmax).

3. The method according to the preceding claim, wherein the at least one individual cell voltage (Vmin,Vmax) is at least one of
a minimum cell voltage (Vmin) measured among the cell voltages (Vc1,Vc2,Vc3) of the plurality of individual battery cells (11a,11b,11c), and
a maximum cell voltage (Vmax) measured among the cell voltages (Vc1,Vc2,Vc3) of the plurality of individual battery cells.

4. The method according to any of the two preceding claims, wherein the processor (40) is configured to determine a charging capacity (C) of the battery (11) by integrating the battery pack current (Ipack) over time between a predetermined first set point, based on the minimum cell voltage (Vmin), and a predetermined second set point, based on the maximum cell voltage (Vmax).

5. The method according to any of the three preceding claims, wherein the first and/or second predetermined set point is based on an identification of the battery (11) and/or the electric system (10) comprising the battery (11).

6. The method according to any of the preceding claims, wherein the diagnostic protocol (P) comprises executing a discharge phase (Td) followed by a charge phase (Tc) of the battery (11).

7. The method according to the preceding claim, wherein the diagnostic protocol (P) comprises at least one rest period (R1,R2,R3) before and/or after the discharge phase (Td) or the charge phase (Tc), wherein during the at least one rest period (R1,R2,R3) the charging system (20) is maintained in an idle state.

8. The method according to any of the preceding claims, wherein the diagnostic protocol (P) further comprises a calibration phase (Th) configured to bring the battery (11) in a predefined state by at least one of
charging the battery (11) from an initial cell voltage (Vi), that is above a predetermined baseline cell voltage (V0), and subsequently discharging the battery (11) to the predetermined baseline cell voltage (V0); or
discharging the battery (11) from an initial cell voltage (Vi), that is below a predetermined baseline cell voltage (V0), and subsequently charging the battery (11) to the predetermined baseline cell voltage (V0).

9. The method according to the preceding claim, wherein the charging and/or discharging the battery (11) from the initial cell voltage (Vi) is based on a difference (Δ) between the initial cell voltage (Vi) and the predetermined baseline voltage (V0) of the battery cells.

10. The method according to any of the preceding claims, wherein charging and/or discharging of the battery (11) comprises
providing a constant battery pack current (Ipack) to the battery (11) until reaching a predetermined offset (O) from a destination cell voltage (Vd); and
keeping a battery pack voltage (Vpack) constant to reach the destination cell voltage (Vd).

11. The method according to any of the preceding claims, wherein determining the battery health (C,R) comprises measuring internal resistance (R) of the battery (11) by
drawing/injecting different amounts of current from/to the battery (11) while measuring current and voltage of the battery (11);
wherein the respective different amounts of current are a fraction of the amount of current needed to fully charge the battery (11) in a predetermined period of time; and
determining the internal resistance of the battery (11) based on the measuring current and voltage to the battery (11).

12. The method according to claim 11, wherein the constant rate of drawing/injecting the current is based on the charging capacity (C) of the battery (11) determined according to claim 2.

13. A method of charging a battery (11) powering an electric system (10), the method comprising:
executing the diagnostic protocol (P) according to one of the preceding claims; and
charging the battery (11) up to a predefined state of charge;
wherein the predefined state of charge is based on the battery health (C,R) determined by using the diagnostic protocol (P).

14. A non-transitory computer-readable medium storing instructions that, when executed by one or more processors, cause a device to perform the method according to any of the preceding claims.

15. A system for determining battery health (C,R) of a battery (11) powering an electric system (10), the electric system (10) comprising:
a controller (30) for controlling a charging system (20) to execute a charging protocol for charging and/or discharging the battery (11);
a receiver (50) for receiving, from a monitoring device (12) integrated as part of the electric system (10), one or more characteristics (V,I,T) of the battery (11) while executing the charging protocol; and
a processor (40) for determining the battery health (C,R) based on a combination of the executed charging protocol and received one or more characteristics (V,I,T).
